# EUROPEAN PATENT SPECIFICATION

(11) **EP 3 707 759 B1**
(45) Date of publication and mention of the grant of the patent: **10.07.2024**
(21) Application number: 18807772.1
(22) Date of filing: 30.10.2018
(51) Int. Cl.: H10N 50/01, H10N 59/00, H10B 61/00, G01R 33/09, G01R 33/00

(54) **ANGLED SURFACE REMOVAL PROCESS AND STRUCTURE RELATING THERETO**
VERFAHREN ZUR ENTFERNUNG EINER GENEIGTEN OBERFLÄCHE UND STRUKTUR IM VERHÄLTNIS DAZU
PROCÉDÉ POUR ENLEVER UNE SURFACE INCLINÉE ET STRUCTURE EN RELATION AU PROCÉDÉ

(30) Priority: 07.11.2017 US 201762582502 P
(43) Date of publication of application: 16.09.2020
(60) Divisional application: 24177583.2
(73) Proprietor: Everspin Technologies, Inc., Chandler, AZ 85226 (US)
(72) Inventor: AGGARWAL, Sanjeev, Scottsdale, AZ 85260 (US); NAGEL, Kerry Joseph, Scottsdale, AZ 85266 (US)
(74) Representative: Eisenführ Speiser
(86) International application number: PCT/US2018/058217
(87) International publication number: WO 2019/094228

(56) References cited:
- WO-A1-2012/085296
- JP-A- 2005 209 834
- US-A1- 2011 244 599
- US-A1- 2012 111 826

## Description

### INTRODUCTION

Fabrication of an integrated circuit device may, in some cases, result in circuit elements having angled surfaces, or structures having a knife-edge like configuration. These angled surfaces may, in some cases, detrimentally affect the performance of the integrated circuit device. For example, three-axis sensors fabricated using integrated circuit fabrication processes are widely used (e.g., in devices) to measure or detect physical parameters, such as position, motion, force, acceleration, temperature, pressure, etc. Some of these sensors use flux guides to measure an out of plane magnetic signal using an in plane device. Fabrication of the flux guides using integrated circuit fabrication techniques may result in angled surfaces that detrimentally affect the performance of the sensor device. The current disclosure describes an inexpensive integrated circuit fabrication process that may be used to remedy the above-described problems. The scope of the current disclosure, however, is defined by the attached claims, and not by the ability to solve any specific problem.

In that regard, JP 2005-209384 A relates to improving the reliability of a magnetic memory by ensuring that it does withstand a breakdown voltage between the bit-line of a magnetic memory, and the wiring connected to the lower layer of a magnetic memory element. For this purpose, a process is provided which forms a recess in an insulation film which covers the magnetic memory element connected on a current drive line so as to expose the memory element on the bottoms.

Further, WO 2012/085296 A1 relates to an integrated magnetoresistive device, where a substrate of semiconductor material is covered on a first surface by an insulating layer. A magnetoresistor of ferromagnetic material extends in the insulating layer and defines a sensitivity plane of the sensor. A concentrator of ferromagnetic material including at least one arm, extending in a transversal direction to the sensitivity plane and vertically offset to the magnetoresistor. In this way, magnetic flux lines directed perpendicularly to the sensitivity plane are concentrated and deflected so as to generate magnetic-field components directed in a parallel direction to the sensitivity plane.

Finally, US 2012/0111826 A1 relates to damascene processes using physical vapor deposition (PVD) sputter carbon film as a chemical mechanical planarization (CMP) stop layer for forming a magnetic recording head. One such process includes providing an insulator, removing a portion of the insulator to form a trench within the insulator, depositing a carbon material on first portions of the insulator using a physical vapor deposition process, disposing at least one ferromagnetic material on second portions of the insulator to form a pole including a portion of the ferromagnetic material within the trench, and performing a chemical mechanical planarization on the at least one ferromagnetic material using at least a portion of the carbon material as a stop for the chemical mechanical planarization.

### BRIEF DESCRIPTION OF THE DRAWINGS

The present invention may be implemented in connection with embodiments illustrated in the attached drawings. These drawings show different aspects of the present invention and, where appropriate, reference numerals illustrating like structures, components, materials and/or elements in different figures are labeled similarly. It is understood that various combinations of the structures, components, and/or elements, other than those specifically shown, are contemplated and are within the scope of the present invention as defined by the claims.

For the sake of brevity, certain permutations and combinations are not discussed and/or illustrated separately herein. Notably, an embodiment or implementation described herein as "exemplary" is not to be construed as preferred or advantageous, for example, over other embodiments or implementations; rather, it is intended reflect or indicate the embodiment(s) is/are "example" embodiment(s).
FIG. 1 illustrates an exemplary three-axis magnetic field sensor of the current disclosure;
FIG. 2 is a flow chart showing an exemplary fabrication process of the magnetic field sensor of FIG. 1;
FIGs. 3A-3J are schematic cross-sectional illustrations of a magnetic field sensor at different stages during the fabrication process of FIG. 2;
FIG. 4 is a flow chart showing another exemplary fabrication process of the magnetic field sensor of FIG. 1; and
FIGs. 5A-5F are schematic cross-sectional illustrations of a magnetic field sensor at different stages during the fabrication process of FIG. 4.

Although many of these figures illustrate a structure comprising different distinct layers and interfaces, this is only a simplification. For example, although the different layers may be sequentially and individually formed during fabrication, as would be recognized by those of ordinary skill in the art, the materials that make up the various layers may alloy with (e.g., intermix with, diffuse into, etc.) the materials of adjacent layers during subsequent processing (e.g., high temperature processing operations, such as, annealing, etc.). Therefore, a person skilled in the art would recognize that, although the different layers may appear as separate regions with distinct interfaces immediately after formation of these layers, after subsequent processing operations, the materials of the different layers may alloy together to form a single alloyed region having a higher concentration of different materials at the interface between different layers. Thus, in some cases, it may be difficult to distinguish the different layers and interfaces from a fabricated sensor without physical or chemical analysis.

Notably, for simplicity and clarity of illustration, certain aspects of the figures depict the general structure and/or manner of construction of the various embodiments. Descriptions and details of well-known features and techniques may be omitted to avoid unnecessarily obscuring other features. Elements in the figures are not necessarily drawn to scale; the dimensions of some features may be exaggerated relative to other elements to improve understanding of the example embodiments. For example, one of ordinary skill in the art appreciates that the cross-sectional views are not drawn to scale and should not be viewed as representing proportional relationships between different layers, regions, or features. The cross-sectional views are provided to help illustrate the processing steps performed by simplifying the various layers to show their relative positioning. Moreover, while certain layers and features are illustrated with straight 90-degree edges, in actuality or practice such layers may be more "rounded" and gradually sloping.

### DETAILED DESCRIPTION

The following description is merely illustrative and is not intended to limit the described embodiments and their uses. Any embodiment or implementation described herein as exemplary is not necessarily to be construed as preferred or advantageous over other implementations. Rather, the term "exemplary" is intended or used in the sense of an "example" rather than "ideal" or "preferred" or "advantageous" relative to other implementations or embodiments. Further, the terms "comprise," "include," "have" and any variations thereof are used synonymously to denote or describe non-exclusive inclusion. As such, a process, method, article, or apparatus that uses such terms does not include only those steps, structures, or elements, but may include other steps, structures, or elements not expressly listed or inherent to such process, method, article, or apparatus. In addition, the terms "top," "bottom," "first," "second," and the like, herein do not denote any order, quantity, or importance, but rather are used to distinguish an element, a structure, a step or a process from another. Moreover, the terms "a" and "an" herein do not denote a limitation of quantity, but rather denote the presence of at least one of the referenced item.

All numeric values disclosed herein (including all disclosed thickness values, limits, and ranges) may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified). Moreover, in the claims, values, limits, and/or ranges of the thickness and atomic composition of, for example, the described layers/regions, mean the value, limit, and/or range ±10%.

All patents, applications, published applications and other publications referred to herein are incorporated by reference in their entirety. Unless defined otherwise, all terms of art, notations, and other scientific terms or terminology used herein have the same meaning as is commonly understood by one of ordinary skill in the art to which this disclosure belongs. Some of the components, structures, and/or processes described or referenced herein are well understood and commonly employed using conventional methodology by those skilled in the art. Therefore, these components, structures, and processes will not be described in detail. If a definition or description set forth in this disclosure is contrary to, or otherwise inconsistent with, a definition and/or description in these references, the definition and/or description set forth in this disclosure prevails over those in the references that are incorporated herein by reference. None of the references described or referenced herein is admitted to be prior art to the current disclosure.

The fabrication of an integrated circuit in the form of a magnetic field sensor is described below in accordance with the invention. The current disclosure can be applied in the fabrication of any integrated circuit device, such as, for example, a magnetoresistive memory device (MRAM, etc.) or another device outside the invention.

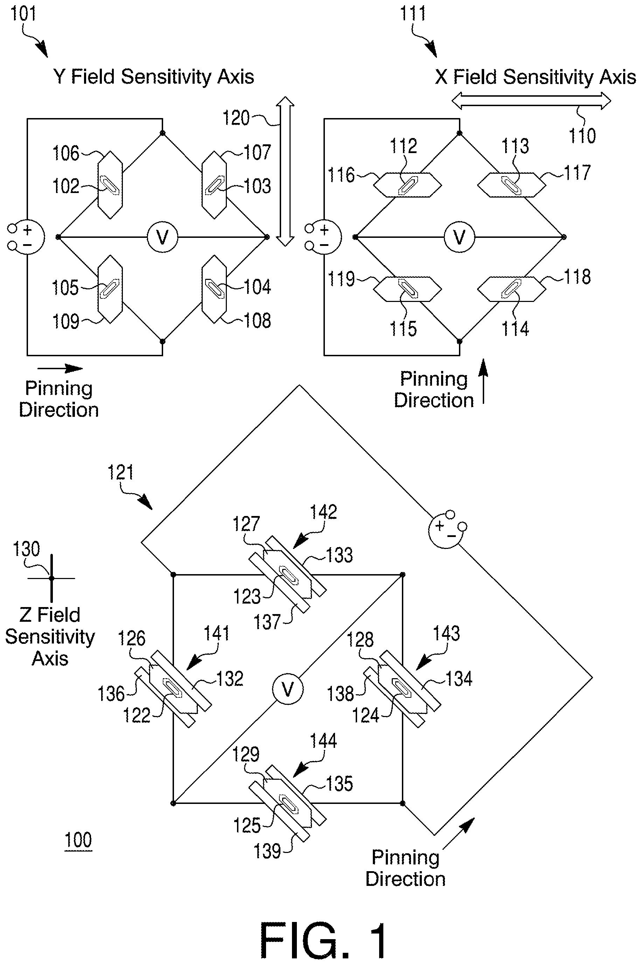

FIG. 1 illustrates an exemplary magnetic field sensor 100 formed with first, second, and third differential sensors 101, 111, 121 for detecting the component directions of an applied field along a first axis 120 (e.g., the Y-axis direction), a second axis 110 (e.g., the X-axis direction), and a third axis 130 (e.g., the Z-axis direction), respectively. The Z-axis direction is represented as a dot and cross-hairs as going either into or out of the page on which FIG. 1 is situated. Exemplary embodiments of the first and second sensors 101, 111 are described in detail in U.S. Patent No. 8,390,283. Each sensor 101, 111, 121 is formed with unshielded sense elements that are connected in a bridge configuration. Thus, the first sensor 101 is formed from the connection of a plurality of sense elements 102-105 in a Wheatstone bridge configuration over a corresponding plurality of reference layers 106-109, where each of the reference layers 106-109 is magnetized in the X-axis direction. In similar fashion, the second sensor 111 is formed from the connection of a plurality of sense elements 112-115 in a bridge configuration over a corresponding plurality of reference layers 116-119 that are each magnetized in the y-axis direction that is perpendicular to the magnetization direction of the reference layers 106-109.

The third sensor 121, formed in the same plane as the first and second sensors 101, 111, is formed by connecting a plurality of sense elements 122-125 in a bridge configuration over a corresponding plurality of reference layers 126-129 that are each magnetized in a direction that is at about 45 degrees to the magnetization direction of the reference layers 106-109 and 116-119. The third sensor 121 further includes flux guides 132-135 positioned adjacent to the right edge of sense elements 122-125, and flux guides 136-139 positioned adjacent to the left edge of sense elements 122-125, respectively. Flux guides 132,137, 134, and 139 are positioned above sense elements 122-125, and flux guides 136, 133, 138, and 135 are positioned below sense elements 122-125. The first and second sensors 101, 111 are configured to detect applied magnetic fields along the first and second axes 120, 110. As would be recognized by a person of ordinary skill in the art, the flux guides 132-139 are configured to guide a magnetic field in the Z-direction into the XY plane such that the third sensor 121 can detect the magnetic field in, e.g., the X-direction. U.S. Patent Nos. 8,390,283 and 8,518,734 describe magnetic field sensors incorporating flux guides in greater detail.

Magnetic field sensor 100 is fabricated using conventional processes used in semiconductor processing. For example, the processing may include known lithographic processes. The fabrication of integrated circuits such as magnetic field sensors, microelectronic devices, micro electro mechanical devices, microfluidic devices, and photonic devices involves the formation of a multiple layers of materials one above the other. These multiple layers may be formed by sequentially depositing, growing, sputtering, evaporating and/or providing (hereinafter collectively referred to as "depositing" or other verb tense (e.g., "deposit" or "deposited")) the different layers one above the other, and in some cases, subjecting the deposited layers to further processing (e.g., annealing, polishing, etching, etc.). In some cases, some of these deposited layers may be patterned so various regions of a layer have different electrical or other characteristics, and interconnected to create electrical components and circuits.

In some embodiments, these regions of may be created by selectively introducing or removing various materials. The patterns that define such regions are often created by lithographic processes. For example, a layer of photoresist is applied onto a layer overlying a wafer substrate. A photo mask (containing clear and opaque areas) is used to selectively expose the photoresist by a form of radiation, such as ultraviolet light, electrons, or x-rays. Either the photoresist exposed to the radiation, or that not exposed to the radiation, is removed by the application of a developer. An etch may then be employed/applied whereby the layer not protected by the remaining resist is patterned. Alternatively, an additive process can be used in which a structure is built up using the photoresist as a template. In the discussion below, for the sake of brevity, conventional techniques related to semiconductor processing will not be described in detail.

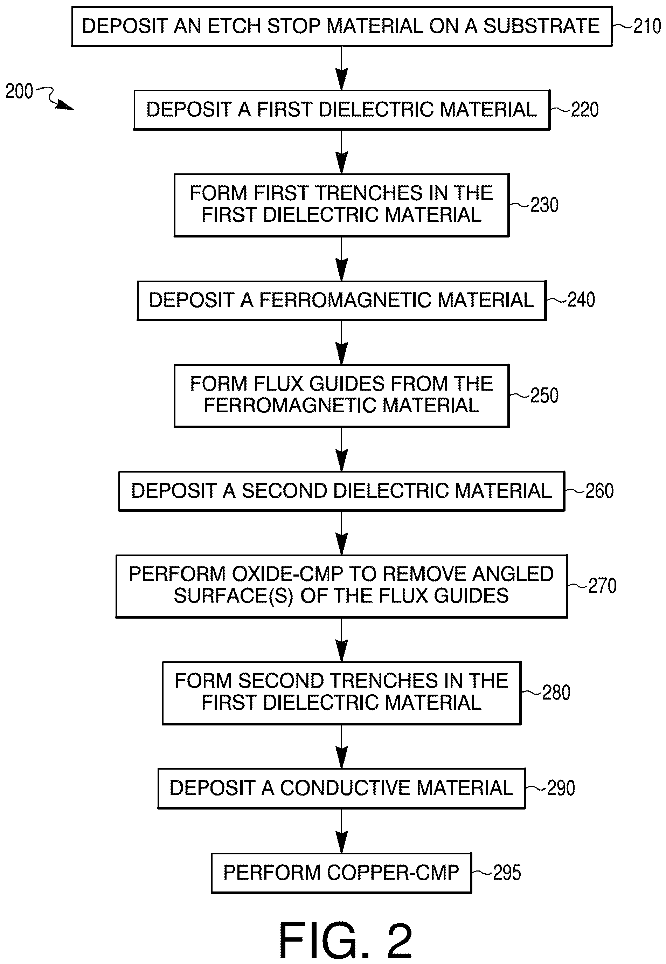

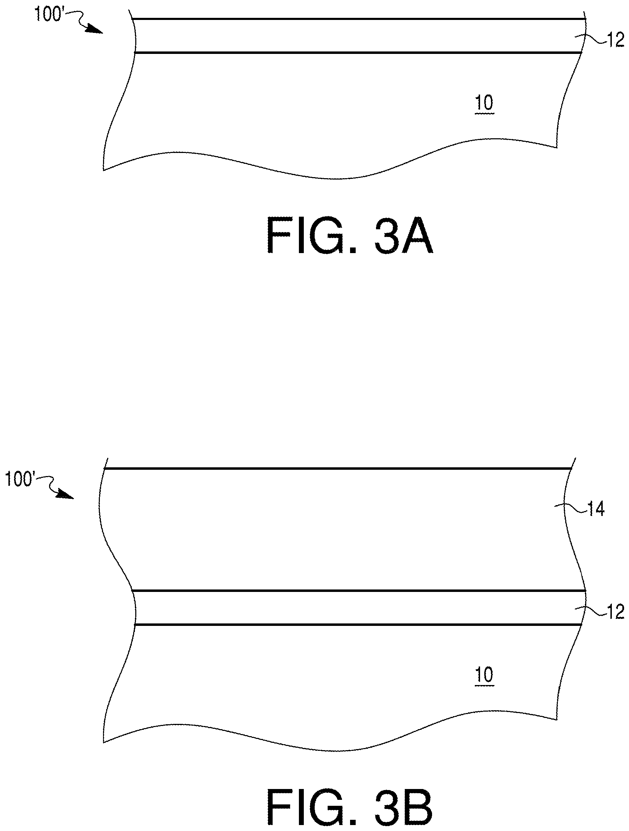

FIG. 2 is a simplified flow chart that illustrates some of the processing steps of an exemplary fabrication method 200 of magnetic field sensor 100. FIGs. 3A-3J are schematic illustrations of a partially formed sensor 100' during different stages of the fabrication process. In the description below, reference will be made to FIGs. 2 and 3A-3J. An etch stop material may first be deposited over a substrate 10 to form an etch stop layer 12 (step 210). FIG. 3A is a schematic illustration of the partially formed sensor 100' with an etch stop layer 12 formed on substrate 10. It should be noted that although the etch stop layer 12 is illustrated as being formed directly on a surface of the substrate 10, this is only exemplary. In some embodiments, the etch stop layer 12 may be formed on an exposed surface of one or more layers formed on the substrate 10. In some embodiments, the etch stop layer 12 may be eliminated. Any material that is selective with respect to the etching process used to form the trenches described below (i.e., first and second trenches 16, 26 on first dielectric layer 14) may be used to form the etch stop layer 12. In some embodiments, materials such as, for example, silicon nitride (Si₃N₄), etc. may be used to form the etch stop layer 12.

A first dielectric material may then be deposited on the exposed surface of the etch stop layer 12 to form a first dielectric layer 14 (step 220). FIG. 3B is a schematic illustration of the partially formed sensor 100' with the first dielectric layer 14 formed on the etch stop layer 12. In some embodiments, an oxide material (such as, for example, silicon dioxide, silicon oxide, etc.) may be used as the first dielectric material. However, in general, any electrically nonconductive material (such as, for example, tetraethyl orthosilicate (TEOS), silicon nitride, a low-k ILD material, etc., or combinations thereof) may be used as the first dielectric material. It should be noted that, in some embodiments, the etch stop layer 12 may not be provided (e.g., step 210 may be eliminated). In such embodiments, the first dielectric layer 14 may be formed directly on substrate 10 (or on the surface of one or more other layers deposited on the substrate 10).

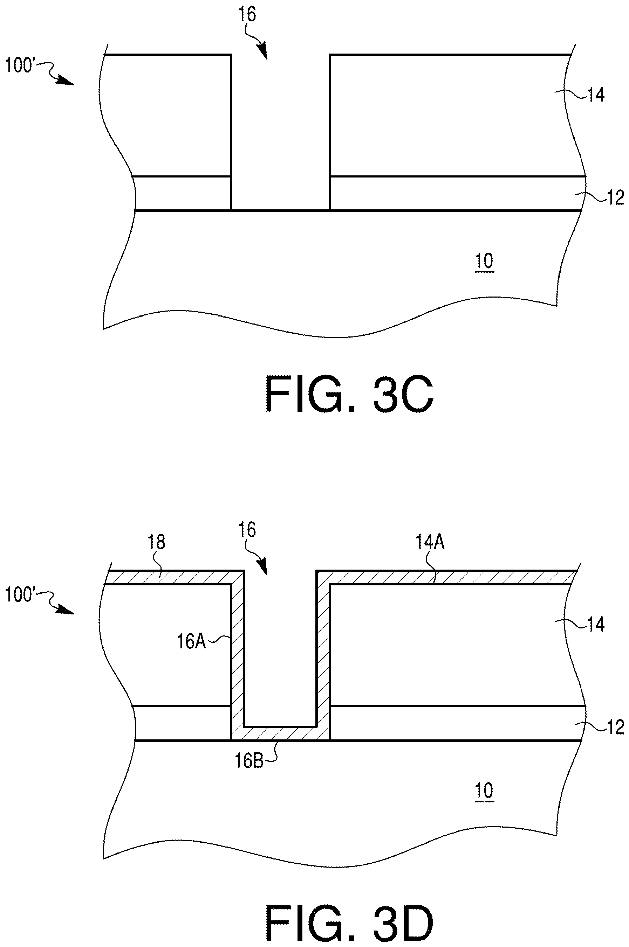

A plurality of first trenches 16 are then etched through the first dielectric layer 14 (step 230). FIG. 3C is a schematic illustration of the partially formed sensor 100' with a single first trench 16 formed on the first dielectric layer 14. Though only one trench 16 is shown, those of ordinary skill in the art will understand that any suitable number of trenches 16 may be etched. In some embodiments, trench 16 may have a width between 0.15-1.0 micrometers (µm), or preferably between 0.35-0.55 µm. In some embodiments, trench 16 may have a depth between 0.3-2.0 µm, or preferably between 0.7-1.3 µm. In some embodiments, step 230 may include depositing a photo resist (or a hardmask) on the surface of the first dielectric layer 14 and patterning the photoresist (e.g., using lithographic techniques) to expose the first dielectric layer 14 in a pattern corresponding to the desired configuration of the first trenches 16, and then etching the exposed areas of the first dielectric layer 14 to form the first trenches 16. Any etching process, such as, for example, reactive ion etching (RIE) may be used to form the first trenches 16. As known to those of ordinary skill in the art, RIE uses beams of charged ions to etch through the first dielectric layer 14 (and in some cases, the etch stop layer 12) and form the first trenches 16. The impact of the ions ablates the areas of the first dielectric layer 14 not covered by the photo resist (or hard mask). In some embodiments, the etch process may be time and/or end point monitored to stop the etch at the desired location (e.g., in the etch stop layer 12, at the end of the etch stop layer 12, at the beginning of the etch stop layer 12, etc.).

A ferromagnetic material 18 may then be deposited on the surface of the partially formed sensor 100' (step 240). FIG. 3D is a schematic illustration of the partially formed sensor 100' with the ferromagnetic material 18 disposed on the exposed surfaces of the first dielectric layer 14 and the first trench 16. Ferromagnetic material 18 may be a material having a high magnetic permeability such as, for example, a nickel-iron alloy (NiFe), or a Cobalt-Iron-Boron alloy (CoFeB). In some embodiments, ferromagnetic material 18 may be a nickel-iron alloy having iron between 10-40 atomic weight %, or preferably having iron between 15-21 atomic weight %. Magnetic permeability refers to the degree of magnetization that a material obtains in response to an applied magnetic field. In general, any material having a high magnetic permeability (e.g., magnetic permeability similar to NiFe) may be used as the ferromagnetic material 18. In some embodiments, ferromagnetic material 18 may have a relative permeability (µ/µ₀) greater than 4000. As illustrated in FIG. 3B, the deposited ferromagnetic material 18 may form a conformal coating on the exposed surface of the partially formed sensor 100' and coat the top surface 14A of the first dielectric layer 14, and the sidewalls 16A and base 16B of the first trenches 16.

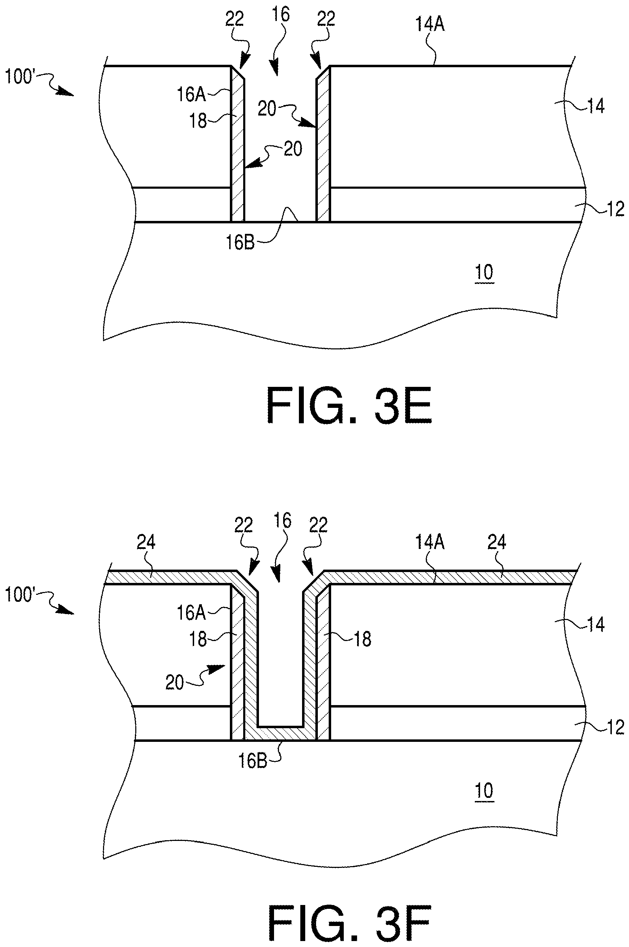

The deposited ferromagnetic material 18 is then etched to form flux guides 20 (step 250). During this step, portions of the deposited ferromagnetic material 18 is etched away from the surface of the partially formed sensor 100' to pattern the ferromagnetic material 18 in the desired shape (e.g., bar-shaped or otherwise shapes having a high aspect ratio) and configuration of the flux guides 20. In some embodiments, in step 250, the ferromagnetic material 18 is etched away from the top surface 14A of the first dielectric layer 14 and the base 16B of the first trenches 16. FIG. 3E is a schematic illustration of the partially formed sensor 100' with the ferromagnetic material 18 etched from the top surface 14A of the first dielectric layer 14 and the base 16B of the first trenches 16. Any etching process, such as, for example, RIE, may be used for etching the ferromagnetic material 18 in step 250. After fabrication of the sensor, the retained ferromagnetic material 18 on the sidewalls 16B form the flux guides 20 (also referred to as cladding, flux concentrators, or magnetically permeable layers) of the sensor. In some embodiments, flux guides 20 may have a thickness between 3 to 150 nanometers (nm), or preferably between 10 to 50 nm. In some embodiments, the thickness of the flux guides 20 may vary from top to bottom of the trench 16 (due to step coverage, etc.). Although FIG. 3E illustrates the ferromagnetic material 18 being retained only on the sidewalls 16A of the first trenches 16, this is only exemplary. In some embodiments, a portion of the ferromagnetic material 18 may also be retained on the base 16B of the first trenches 16. In step 250, during etching, the anisotropy of the etching process etches the ferromagnetic material 18 from the top surface 14A and the base 16B while retaining at least a portion of the ferromagnetic material 18 on the sidewalls 16A. However, after the etching, a portion of the ferromagnetic material 18 on the sidewalls 16A proximate the top surface 14A (i.e., at the mouth of the first trenches 16) forms an angled surface 22. This angled surface 22 is undesirable because it affects the magnetic performance of the flux guides 20 and the sensor.

A second dielectric material is then deposited on the surface of the partially formed sensor 100' to form a second dielectric layer 24 (step 260). FIG. 3F is a schematic illustration of the partially formed sensor 100' with the second dielectric layer 24 forming a conformal coating over the top surface 14A of the first dielectric layer 14, and the surfaces inside the first trenches 16 (i.e., coating over the ferromagnetic material 18 on the sidewalls 16A and the exposed base 16B). As illustrated in FIG. 3F, the second dielectric layer 24 over the angled surface 22 of the ferromagnetic material 18 also has an angled surface or a knife-edge shape. Any electrically insulating material (e.g., TEOS) may be used as the second dielectric material. In some embodiments, the second dielectric material may be the same as the first dielectric material used to form the first dielectric layer 14. The second dielectric layer 24 may form an insulating or protective layer over the flux guides 20.

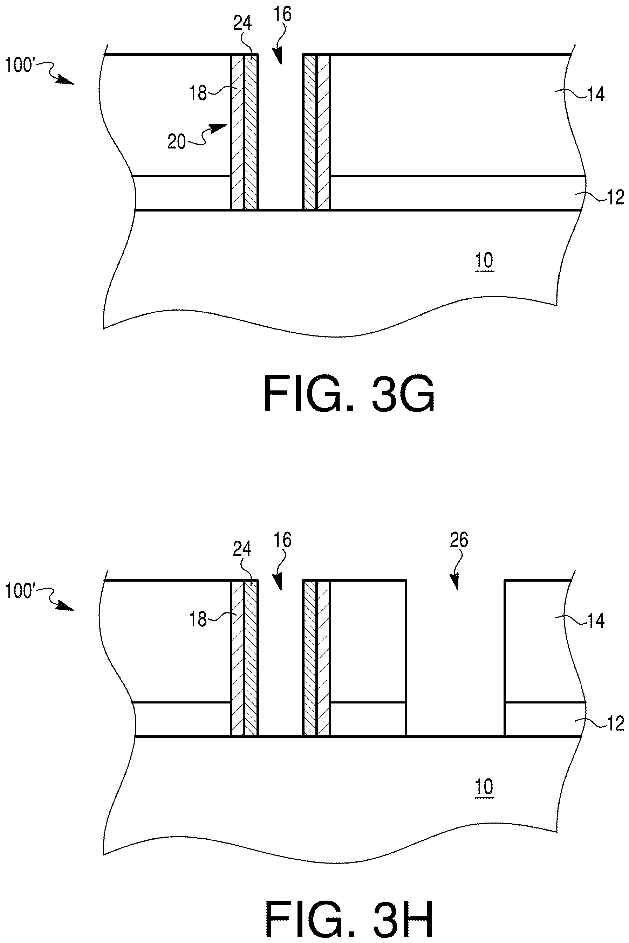

The top surface of the partially formed sensor 100' is now polished to remove the angled surface 22 of the flux guides 20 (step 270). Such polishing also removes portions of surface 14a. In some embodiments, a chemical mechanical polishing (CMP) process may be used for the polishing. As would be familiar to a person of ordinary skill in the art, during CMP, the top surface of the partially formed sensor 100' is pressed down against a rotating platen, which holds a compliant polishing pad. Concurrently, an abrasive chemical slurry is dispensed onto the rotating platen. The abrasive particles retained on the porous pad surface removes material from the top surface of the partially formed sensor 100' as the platen rotates. In some embodiments, during step 270, the parameters of the CMP process (e.g., slurry, pressure, polishing pad, rotating speed, etc.) are selected to result in an oxide-CMP process. In step 270, polishing using the oxide-CMP process is continued until the angled surface 22 of the flux guide 20 is removed. FIG. 3G is a schematic illustration of the partially formed sensor 100' after step 270. In some embodiments, a different CMP process (e.g., a metal-CMP process may be carried out to remove the angled surface 22).

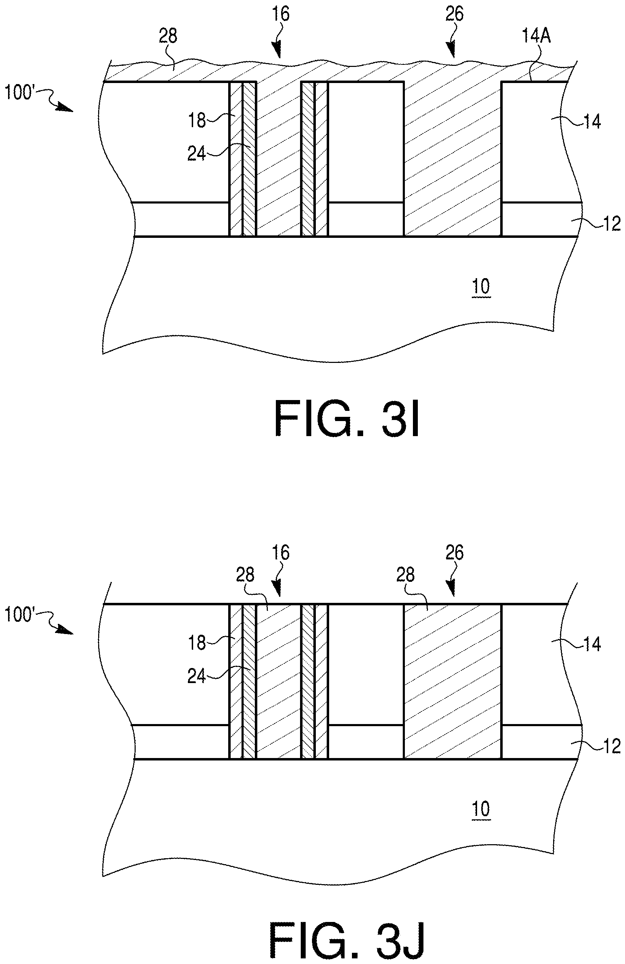

A plurality of second trenches 26 is then etched through the first dielectric layer 14 (step 280). FIG. 3H is a schematic illustration of the partially formed sensor 100' with a second trench 26 formed on the first dielectric layer 14. The second trenches 26 may be etched using processes similar to those used to etch the plurality of first trenches 16 in step 230. An electrically conductive material 28 is then deposited over the partially formed sensor 100' to fill the first and second trenches 16, 26 (step 290). In some embodiments, multiple materials (e.g., a barrier layer material in addition to the conductive material 28, etc.) may be deposited into the first and second trenches 16, 26 in step 290. FIG. 3I is a schematic illustration of the partially formed sensor 100' with a conductive material 28 deposited thereon. Although any electrically conductive material 28 may be used, in some embodiments, the electrically conductive material may be copper (Cu). As illustrated in FIG. 3I, during step 290, the deposited electrically conductive material 28 may also deposit over the top surface of the first dielectric layer 14.

The electrically conductive material 28 on the top surface of the first dielectric layer 14 is now removed by polishing (step 295). In some embodiments, a metal-CMP or a copper-CMP process may be used in step 295. In the CMP process of step 295, the parameters that control the CMP process (e.g., slurry, pressure, polishing pad, rotating speed, etc.) are selected to result in a metal-CMP or a copper-CMP process. During step 295, the electrically conductive material 28 on the top surface 14a of the first dielectric layer 14 is removed. FIG. 3J is a schematic illustration of the partially formed sensor 100' with a conductive material 28 filling the first and second trenches 16, 26. Further processing steps are then performed on the partially formed sensor 100' to form a magnetic field sensor. Since these processing steps are known to people skilled in the art (e.g., described in U.S. Patent No. 8,390,283 and 8,518,734), they are not described herein.

In some embodiments, the angled surface 22 of the flux guide 20 at the mouth of the first trench 16 may not be removed using oxide-CMP. Instead, a metal-CMP or a copper-CMP process that is used to planarize metallization (e.g., a step similar to step 295) may be used to remove the angled surface 22 of the flux guides 20. However, in some cases, a portion of the angled surface 22 may remain in the flux guides when a copper-CMP process is used to remove the angled surface. Therefore, some embodiments of the present disclosure contemplate removing the angled surface 22 of the flux guides 20 using an oxide-CMP process prior to the deposition of the metallization (e.g., step 290). In some cases, the angled surface 22 of the flux guides 20 may be more effectively removed using an oxide-CMP process prior to the deposition of the metallization than by using a copper-CMP process after the deposition of the metallization.

The fabrication flow illustrated in FIG. 2 is only exemplary. Many modifications are possible. For example, the order of some of the steps of method 200 may be changed, or one more steps of method 200 may be eliminated altogether.

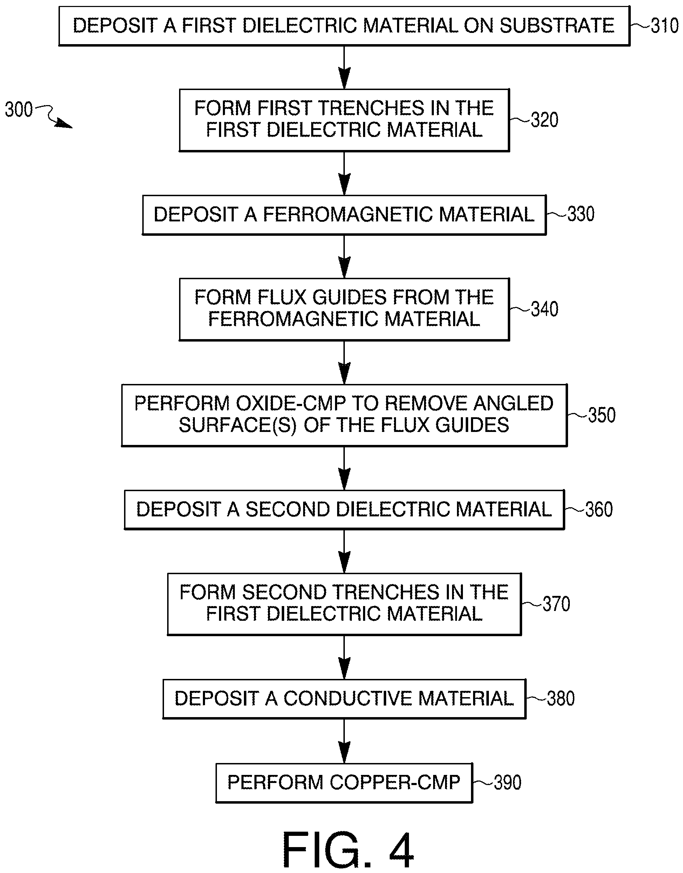

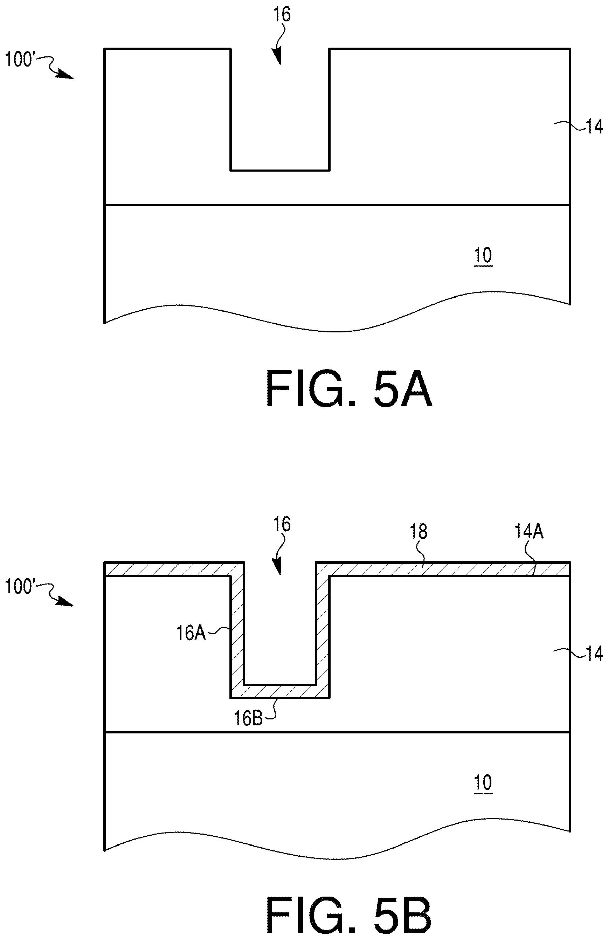

FIG. 4 is a simplified flow chart that illustrates another exemplary fabrication method 300 of magnetic field sensor 100. FIGs. 5A-5F are schematic illustrations of a partially formed sensor 100' during different stages of the fabrication process. In the discussion below reference will be made to FIGs. 4-5F. Since the processing steps in method 300 of FIG. 4 are the same as the processing steps described with reference to method 200 of FIG. 2, they will not be described in detail.

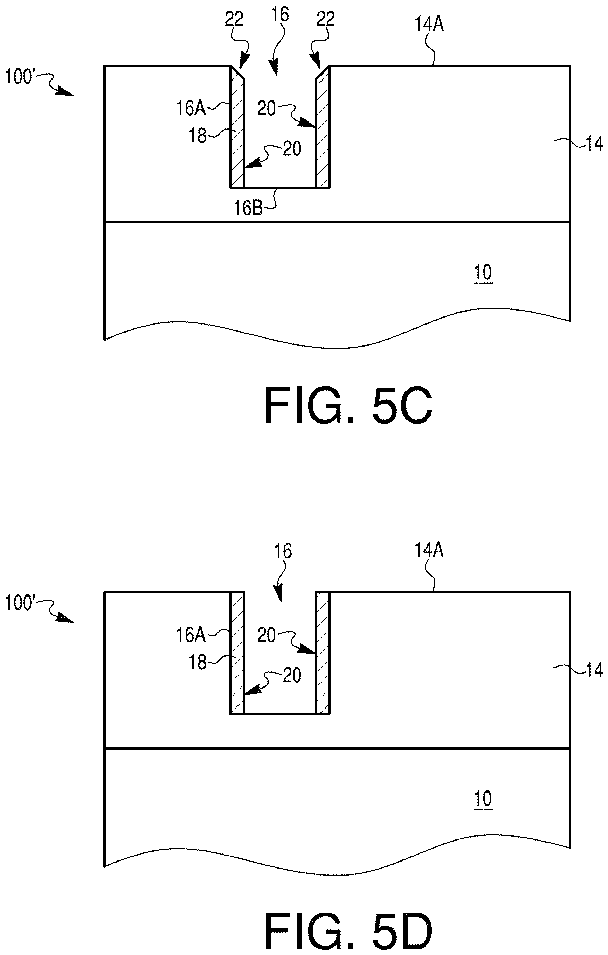

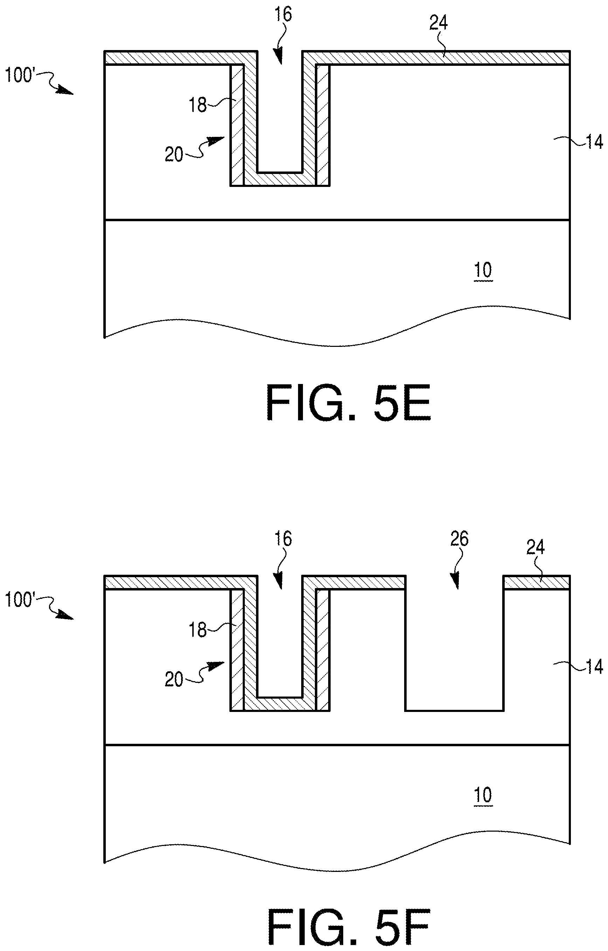

The first dielectric layer 14 is formed on a substrate 10 by depositing the first dielectric material (step 310). In some embodiments, similar to step 210 of method 200, an etch stop layer 12 may first be formed on substrate 10 and the first dielectric layer 14 may be formed on the etch stop layer 12. A plurality of first trenches 16 is then formed in the first dielectric layer 14 (step 320). As explained previously, in some embodiments, the trenches 16 may have a width between 0.15-1.0 µm (or between 0.35-0.55 µm) and a depth between 0.3-2.0 µm (or between 0.7-1.3µm). FIG. 5A is a schematic illustration of the partially formed sensor 100' with a first trench 16 in the first dielectric layer 14. The ferromagnetic material 18 may then be deposited on the surface of the partially formed sensor 100' to form a conformal coating (step 330). Ferromagnetic material 18 may be a material having a high magnetic permeability such as, for example, a nickel-iron alloy (NiFe), or a Cobalt-Iron-Boron alloy (CoFeB). In some embodiments, ferromagnetic material 18 may have a relative permeability (µ/µ₀) greater than 4000. In some embodiments, ferromagnetic material 18 may be a nickel-iron alloy having iron between 10-40 atomic weight %, or preferably having iron between 15-21 atomic weight %. FIG. 5B is a schematic illustration of the partially formed sensor 100' after deposition of the ferromagnetic material 18. The deposited ferromagnetic material 18 is then etched to form flux guides 20 on the sidewalls 16A of the first trenches 16 (step 340). For example, as described above, the ferromagnetic material 18 may be etched or otherwise removed from surfaces 14a and 16b, as shown in FIG. 5B. FIG. 5C is a schematic illustration of the partially formed sensor 100' with flux guides 20 formed on the sidewalls 16A of the first trench 16. In some embodiments, the flux guides 20 may have a thickness between 3-150 nm (or between 10-50 nm). As described with reference to step 250 of method 200, the etching process of step 340 results in angled surfaces 22 on the flux guides 20 at the mount of the first trenches 16. The angled surface 22 is then removed by a CMP process (e.g., metal-CMP, oxide-CMP, etc.) (step 350). In some embodiments, an oxide-CMP process may be used in step 350 to more effectively remove the angled surface 22. FIG. 5D is a schematic illustration of the partially formed sensor 100' after removal of the angled surface 22 from the flux guides 20 using a CMP process, which removes portions of surface 14a as well as the angled surfaces 22. The second dielectric material (e.g., TEOS) is then deposited over the partially formed sensor 100' to form a second dielectric layer 24 (step 360). FIG. 5E is a schematic illustration of the partially formed sensor 100' with the second dielectric material forming a conformal coating on the surface. A plurality of second trenches 26 is formed through the first and second dielectric layers 14, 24 (step 370). FIG. 5F is a schematic illustration of the partially formed sensor 100' after formation of the second trenches 26. An electrically conductive material, such as, for example, copper (Cu) (alone or Cu in addition to layers of other materials, such as, for example, barrier layer materials, etc.) is then deposited on the surface of the partially formed sensor 100' to fill the first and second trenches 16, 26 (step 380). A copper-CMP process is then performed to planarize the surface (step 390). Further processing is then carried on the partially formed sensor 100' to form the magnetic field sensor 100.

As explained previously, the methods 200, 300 discussed above describe the fabrication of a magnetic field sensor 100 with flux guides 20 in accordance with the invention. Outside the invention, disclosed methods may be used to fabricate any integrated circuit device or portions thereof.

In one aspect, a method of fabricating an integrated circuit device is disclosed. The method may include depositing a first dielectric material above a substrate, forming a trench in the first dielectric material, depositing a ferromagnetic material in the trench, and etching the ferromagnetic material to form a circuit element having an angled surface. The method may also include removing the angled surface of the circuit element using chemical mechanical polishing (CMP) process, and depositing an electrically conductive material in the trench after the step of removing the angled surface.

Various embodiments of the disclosed method may, additionally or alternatively, include one or more of the following aspects: the ferromagnetic material may be an alloy including one or more of nickel, iron, cobalt, or boron; the CMP process may be one or an oxide CMP process of a metal CMP process; the step of etching the ferromagnetic material may include etching the deposited ferromagnetic material to form the circuit element on a sidewall of the trench with the angled surface positioned proximate an opening of the trench; the method may further include depositing a second dielectric material on the circuit element prior to the step of removing the angled surface; the method may further include depositing a second dielectric material on the circuit element after the step of removing the angled surface; the step of etching the ferromagnetic material to form the circuit element may include removing the deposited ferromagnetic material from a base of the trench to form a circuit element having a thickness between 3-150 nm on a sidewall of the trench; the step of etching the ferromagnetic material to form the circuit element may include etching the ferromagnetic material using reactive ion etching; the step of forming a trench may include forming a trench having a width between 0.15-1.0 µm and a depth between 0.3-2.0 µm; the trench may be a first trench, and the method further include forming a second trench in the first dielectric material after the step of removing the angled surface; the trench may be a first trench, and the method may further include forming a second trench in the first dielectric material after the step of removing the angled surface, and wherein depositing the electrically conductive material includes depositing copper in the first trench and the second trench; the integrated circuit may be a magnetic field sensor and the circuit element may be a flux guide.

In another aspect, a method of fabricating an integrated circuit device is disclosed. The method may include depositing a first dielectric material above a substrate, forming a first trench in the first dielectric material, depositing a ferromagnetic material in the first trench, and etching the ferromagnetic material to remove the deposited ferromagnetic material from a base of the first trench to form a circuit element on a sidewall of the first trench. The circuit element may have an angled surface proximate an opening of the first trench. The method may also include removing the angled surface of the circuit element, forming a second trench on the first dielectric material, and depositing an electrically conductive material in the first trench and the second trench after the step of removing the angled surface.

Various embodiments of the disclosed method may, additionally or alternatively, include one or more of the following aspects: the step of removing the angled surface may include removing the angled surface using one of an oxide chemical mechanical polishing process (oxide CMP) or a metal chemical mechanical polishing process (metal CMP); the ferromagnetic material may be one of a nickel-iron alloy or a cobalt-iron-boron alloy; the ferromagnetic material may be an alloy including nickel and iron; the method may further include depositing a second dielectric material on the circuit element prior to the step of removing the angled surface; the method may further include depositing a second dielectric material on the circuit element after the step of removing the angled surface; the step of etching the ferromagnetic material may include forming the circuit element having a thickness between 3 to 150 nm on the sidewall of the first trench; and the electrically conductive material may be copper.

In one aspect, a method of fabricating an integrated circuit device is disclosed. The method may include depositing a first dielectric material above a substrate, forming a trench in the first dielectric material, depositing a ferromagnetic material in the trench, and etching the ferromagnetic material to form a circuit element having an angled surface. The method may also include removing the angled surface of the circuit element using chemical mechanical polishing (CMP) process, and depositing an electrically conductive material in the trench after the step of removing the angled surface.

Various embodiments of the disclosed method may, alternatively or additionally, also include one or more of the following features: the ferromagnetic material may be an alloy including one or more of nickel, iron, cobalt, or boron; the CMP process may be one of an oxide CMP process or a metal CMP process; the step of etching the ferromagnetic material may include etching the deposited ferromagnetic material to form the circuit element on a sidewall of the trench with the angled surface positioned proximate an opening of the trench; further include depositing a second dielectric material on the circuit element prior to the step of removing the angled surface; further include depositing a second dielectric material on the circuit element after the step of removing the angled surface; the step of etching the ferromagnetic material to form the circuit element may include removing the deposited ferromagnetic material from a base of the trench to form the circuit element having a thickness between 3 to 150 nm on a sidewall of the trench; the step of forming a trench may include forming a trench having a width between 0.15-1.0 µm and a depth between 0.3-2.0 µm; the trench may be a first trench, and the method may further include forming a second trench in the first dielectric material after the step of removing the angled surface; the trench may be a first trench, and the method may further include forming a second trench in the first dielectric material after the step of removing the angled surface, and depositing an electrically conductive material may include depositing copper in the first trench and the second trench; the integrated circuit may be a magnetic field sensor and the circuit element may be a flux guide.

In some aspects, a method of fabricating an integrated circuit device is disclosed. The method may include depositing a first dielectric material above a substrate, forming a first trench in the first dielectric material, depositing a ferromagnetic material in the first trench, and etching the ferromagnetic material to remove the deposited ferromagnetic material from a base of the first trench to form a circuit element on a sidewall of the first trench. The circuit element may have an angled surface proximate an opening of the first trench. The method may also include removing the angled surface of the circuit element, forming a second trench on the first dielectric material, and depositing an electrically conductive material in the first trench and the second trench after the step of removing the angled surface.

Various embodiments of the disclosed method may, alternatively or additionally, also include one or more of the following features: the step of removing the angled surface may include removing the angled surface using one of an oxide chemical mechanical polishing process (oxide CMP) or a metal chemical mechanical polishing process (metal CMP); the ferromagnetic material may be one of a nickel-iron alloy or a cobalt-iron-boron alloy; the ferromagnetic material may be an alloy including nickel and iron; further include depositing a second dielectric material on the circuit element prior to the step of removing the angled surface; further include depositing a second dielectric material on the circuit element after the step of removing the angled surface; the step of etching the ferromagnetic material may include forming the circuit element having a thickness between 3 to 150 nm on the sidewall of the first trench; the electrically conductive material may include copper; the integrated circuit may be a magnetic field sensor and the circuit element may be a flux guide.

Although various embodiments of the present disclosure have been illustrated and described in detail, it will be readily apparent to those skilled in the art that various modifications may be made without departing from the invention as defined by the claims.

## Claims

1. A method of fabricating a magnetic field sensor (100), comprising:
depositing a first dielectric material (14) above a substrate (10);
forming a first trench (16) in the first dielectric material (14);
depositing a ferromagnetic material (18) in the first trench (16);
etching the ferromagnetic material (18) to form a flux guide (20) having an angled surface (22);
removing the angled surface (22) of the flux guide (20) comprising the ferromagnetic material (18) by subjecting the angled surface (22) of the flux guide (20) to an oxide-chemical mechanical polishing (CMP) process; and
depositing an electrically conductive material (28) in the first trench (16) after the step of removing the angled surface.

2. The method of claim 1, wherein the ferromagnetic material (18) is an alloy including one or more of nickel, iron, cobalt, or boron.

3. The method of any of the preceding claims, further comprising:
removing a portion of the electrically conductive material (28) deposited on a top surface of the first dielectric material (14) by subjecting the portion of the electrically conductive material (28) to one of a metal-CMP process or a copper-CMP process.

4. The method of any of the preceding claims, wherein the step of etching the ferromagnetic material (18) includes etching the deposited ferromagnetic material (18) to form the flux guide (20) on a sidewall (16A) of the first trench (16) with the angled surface (22) positioned proximate an opening of the first trench (16).

5. The method of claim 4, wherein the method further comprises:
forming a second trench (26) on the first dielectric material (14); and
depositing the electrically conductive material (28) in the first trench (16) and the second trench (26) after the step of removing the angled surface(22).

6. The method of any of the preceding claims, further including depositing a second dielectric material (24) on the flux guide (20) prior to the step of removing the angled surface (22).

7. The method of any of claims 1 to 5, further including depositing a second dielectric material (24) on the flux guide (20) after the step of removing the angled surface (22).

8. The method of claim 1, wherein the step of etching the ferromagnetic material (18) to form the flux guide (20) includes removing the deposited ferromagnetic material (18) from a base (16B) of the first trench (16) to form the flux guide (20) having a thickness between 3 to 150 nm on the sidewall (16A) of the first trench (16).

9. The method of claim 1, wherein the step of forming the first trench (16) includes forming a trench (16) having a width between 0.15-1.0 µm and a depth between 0.3-2.0 µm.

10. The method of any of the preceding claims, wherein depositing an electrically conductive material (28) includes depositing copper in the first trench (16) and/or the second trench (26).

11. The method of any of the preceding claims, wherein the ferromagnetic material (18) is an alloy including nickel and iron.

12. The method of any of the preceding claims, wherein the step of etching the ferromagnetic material (18) includes forming the flux guide (20) having a thickness between 3 to 150 nm on the sidewall (16A) of the first trench (16).

13. The method of any of the preceding claims, wherein the electrically conductive material (28) includes copper.

14. The method of any of claims 1 to 10, wherein the ferromagnetic material (18) is an alloy including cobalt, iron, and boron.

15. The method of any of the preceding claims, wherein the oxide-CMP process is continued until the angled surface of the flux guide is removed.

## Patentansprüche

1. Verfahren zum Herstellen eines Magnetfeldsensors (100), umfassend:
Aufbringen eines ersten dielektrischen Materials (14) auf ein Substrat (10);
Bilden eines ersten Schlitzes (16) in dem ersten dielektrischen Material (14);
Aufbringen eines ferromagnetischen Materials (18) in dem ersten Schlitz (16);
Ätzen des ferromagnetischen Materials (18) zum Ausbilden eines Flussleiters (20) mit einer abgewinkelten Oberfläche (22);
Entfernen der abgewinkelten Oberfläche (22) des Flussleiters (20), die das ferromagnetische Material (18) umfasst, indem die abgewinkelte Oberfläche (22) des Flussleiters (20) einem oxidchemischen mechanischen Polierprozess (CMP) unterzogen wird; und
Aufbringen eines elektrisch leitenden Materials (28) in dem ersten Schlitz (16) nach dem Schritt des Entfernens der abgewinkelten Oberfläche.

2. Verfahren nach Anspruch 1, wobei das ferromagnetische Material (18) eine Legierung ist, die eines oder mehrere der Elemente Nickel, Eisen, Kobalt oder Bor enthält.

3. Verfahren nach einem der vorhergehenden Ansprüche, ferner umfassend:
Entfernen eines Teils des elektrisch leitenden Materials (28), das auf einer oberen Oberfläche des ersten dielektrischen Materials (14) aufgebracht ist, indem der Teil des elektrisch leitenden Materials (28) einem Metall-CMP-Prozess oder einem Kupfer-CMP-Prozess unterzogen wird.

4. Verfahren nach einem der vorhergehenden Ansprüche, wobei der Schritt des Ätzens des ferromagnetischen Materials (18) das Ätzen des aufgebrachten ferromagnetischen Materials (18) umfasst, um den Flussleiter (20) auf einer Seitenwand (16A) des ersten Schlitzes (16) zu bilden, wobei die abgewinkelte Oberfläche (22) in der Nähe einer Öffnung des ersten Schlitzes (16) angeordnet ist.

5. Verfahren nach Anspruch 4, wobei das Verfahren ferner umfasst:
Ausbilden eines zweiten Schlitzes (26) auf dem ersten dielektrischen Material (14); und
Aufbringen des elektrisch leitenden Materials (28) in dem ersten Schlitz (16) und dem zweiten Schlitz (26) nach dem Schritt des Entfernens der abgewinkelten Oberfläche (22).

6. Verfahren nach einem der vorhergehenden Ansprüche, ferner umfassend das Aufbringen eines zweiten dielektrischen Materials (24) auf den Flussleiter (20) vor dem Schritt des Entfernens der abgewinkelten Oberfläche (22).

7. Verfahren nach einem der Ansprüche 1 bis 5, wobei nach dem Schritt des Entfernens der abgewinkelten Oberfläche (22) ein zweites dielektrisches Material (24) auf den Flussleiter (20) aufgebracht wird.

8. Verfahren nach Anspruch 1, wobei der Schritt des Ätzens des ferromagnetischen Materials (18) zum Ausbilden des Flussleiters (20) das Entfernen des aufgebrachten ferromagnetischen Materials (18) von einer Basis (16B) des ersten Schlitzes (16) umfasst, zum Ausbilden des Flussleiters (20) mit einer Dicke zwischen 3 und 150 nm auf der Seitenwand (16A) des ersten Schlitzes (16).

9. Verfahren nach Anspruch 1, wobei der Schritt des Ausbildens des ersten Schlitzes (16) das Ausbilden eines Schlitzes (16) mit einer Breite zwischen 0,15-1,0 µm und einer Tiefe zwischen 0,3-2,0 µm umfasst.

10. Verfahren nach einem der vorhergehenden Ansprüche, wobei das Aufbringen eines elektrisch leitenden Materials (28) das Aufbringen von Kupfer in dem ersten Schlitz (16) und/oder dem zweiten Schlitz (26) umfasst.

11. Verfahren nach einem der vorhergehenden Ansprüche, wobei das ferromagnetische Material (18) eine Legierung ist, die Nickel und Eisen enthält.

12. Verfahren nach einem der vorhergehenden Ansprüche, wobei der Schritt des Ätzens des ferromagnetischen Materials (18) das Ausbilden des Flussleiters (20) mit einer Dicke zwischen 3 und 150 nm auf der Seitenwand (16A) des ersten Schlitzes (16) umfasst.

13. Verfahren nach einem der vorhergehenden Ansprüche, wobei das elektrisch leitende Material (28) Kupfer enthält.

14. Verfahren nach einem der Ansprüche 1 bis 10, wobei das ferromagnetische Material (18) eine Legierung ist, die Kobalt, Eisen und Bor enthält.

15. Verfahren nach einem der vorhergehenden Ansprüche, wobei das Oxid-CMP-Verfahren fortgesetzt wird, bis die abgewinkelte Oberfläche des Flussleiters entfernt ist.

## Revendications

1. Procédé de fabrication d'un capteur de champ magnétique (100), comprenant :
le dépôt d'un premier matériau diélectrique (14) au-dessus d'un substrat (10) ;
la formation d'une première tranchée (16) dans le premier matériau diélectrique (14) ;
le dépôt d'un matériau ferromagnétique (18) dans la première tranchée (16) ;
la gravure du matériau ferromagnétique (18) pour former un guide de flux (20) ayant une surface inclinée (22) ;
l'enlèvement de la surface inclinée (22) du guide de flux (20) comprenant le matériau ferromagnétique (18) en soumettant la surface inclinée (22) du guide de flux (20) à un processus de polissage mécano-chimique (CMP) d'oxyde ; et
le dépôt d'un matériau électriquement conducteur (28) dans la première tranchée (16) après l'étape d'enlèvement de la surface inclinée.

2. Procédé selon la revendication 1, dans lequel le matériau ferromagnétique (18) est un alliage comportant un ou plusieurs éléments parmi le nickel, le fer, le cobalt ou le bore.

3. Procédé selon l'une quelconque des revendications précédentes, comprenant en outre :
l'enlèvement d'une partie du matériau électriquement conducteur (28) déposé sur une surface supérieure du premier matériau diélectrique (14) en soumettant la partie du matériau électriquement conducteur (28) à un parmi un processus CMP de métal ou un processus CMP de cuivre.

4. Procédé selon l'une quelconque des revendications précédentes, dans lequel l'étape de gravure du matériau ferromagnétique (18) comporte la gravure du matériau ferromagnétique (18) déposé pour former le guide de flux (20) sur une paroi latérale (16A) de la première tranchée (16) avec la surface inclinée (22) positionnée à proximité d'une ouverture de la première tranchée (16).

5. Procédé selon la revendication 4, dans lequel le procédé comprend en outre :
la formation d'une deuxième tranchée (26) sur le premier matériau diélectrique (14) ; et
le dépôt du matériau électriquement conducteur (28) dans la première tranchée (16) et dans la deuxième tranchée (26) après l'étape d'enlèvement de la surface inclinée (22).

6. Procédé selon l'une quelconque des revendications précédentes, comportant en outre le dépôt d'un deuxième matériau diélectrique (24) sur le guide de flux (20) avant l'étape d'enlèvement de la surface inclinée (22).

7. Procédé selon l'une quelconque des revendications 1 à 5, comportant en outre le dépôt d'un deuxième matériau diélectrique (24) sur le guide de flux (20) après l'étape d'enlèvement de la surface inclinée (22).

8. Procédé selon la revendication 1, dans lequel l'étape de gravure du matériau ferromagnétique (18) pour former le guide de flux (20) comporte l'enlèvement du matériau ferromagnétique (18) déposé d'une base (16B) de la première tranchée (16) pour former le guide de flux (20) ayant une épaisseur entre 3 et 150 nm sur la paroi latérale (16A) de la première tranchée (16).

9. Procédé selon la revendication 1, dans lequel l'étape de formation de la première tranchée (16) comporte la formation d'une tranchée (16) ayant une largeur entre 0,15-1,0 µm et une profondeur entre 0,3-2,0 µm.

10. Procédé selon l'une quelconque des revendications précédentes, dans lequel le dépôt d'un matériau électriquement conducteur (28) comporte le dépôt de cuivre dans la première tranchée (16) et/ou dans la deuxième tranchée (26).

11. Procédé selon l'une quelconque des revendications précédentes, dans lequel le matériau ferromagnétique (18) est un alliage comportant du nickel et du fer.

12. Procédé selon l'une quelconque des revendications précédentes, dans lequel l'étape de gravure du matériau ferromagnétique (18) comporte la formation du guide de flux (20) ayant une épaisseur entre 3 et 150 nm sur la paroi latérale (16A) de la première tranchée (16).

13. Procédé selon l'une quelconque des revendications précédentes, dans lequel le matériau électriquement conducteur (28) comporte du cuivre.

14. Procédé selon l'une quelconque des revendications 1 à 10, dans lequel le matériau ferromagnétique (18) est un alliage comportant du cobalt, du fer et du bore.

15. Procédé selon l'une quelconque des revendications précédentes, dans lequel le processus CMP d'oxyde se poursuit jusqu'à ce que la surface inclinée du guide de flux soit enlevée.
